Europäisches Patentamt

European Patent Office

Office européen des brevets

(11) Publication number: **0 241 046**
**A2**

# EUROPEAN PATENT APPLICATION

(21) Application number: 87105372.4

(51) Int. Cl.⁴: **H01L 27/06**

(22) Date of filing: 10.04.87

(30) Priority: 11.04.86 JP 83521/86

(43) Date of publication of application:
14.10.87 Bulletin 87/42

(84) Designated Contracting States:
DE FR GB

(71) Applicant: NEC CORPORATION
33-1, Shiba 5-chome, Minato-ku
Tokyo 108(JP)

(72) Inventor: Satoh, Noboru
NEC Corporation, 33-1, Shiba 5-chome,
Minato-ku
Tokyo(JP)

(74) Representative: Glawe, Delfs, Moll & Partner
Patentanwälte
Postfach 26 01 62 Liebherrstrasse 20
D-8000 München 26(DE)

(54) Semiconductor device having fuse-type memory element.

(57) A semiconductor device including a fuse-type memory element is disclosed. This device comprises a semi-conductor substrate, a field insulating layer on the substrate in which a hollow or trench is formed, and a fuse formed on the field insulating layer so as to run across the hollow or trench. The fuse is broken down on the edge of the hollow so that the broken point of the fuse may be predetermined.

FIG.11

## Semiconductor Device Having Fuse-Type Memory Element

### BACKGROUND OF THE INVENTION

The present invention relates to a semiconductor device having a fuse, and more particularly to a programmable memory device having fuse-type memory elements.

The fuse-type memory element includes a fusible conductive layer operating as a fuse and represents either one or two states in accordance with its conductibility which is determined by whether or not the fusible conductive layer is broken down. It is required for the fuse-type memory element that the fusible conductive layer is effectively broken down by a programming current. Moreover, it is preferred that the fusible conductive layer is broken down at a predetermined portion thereof.

### SUMMARY OF THE INVENTION

Therefore, an object of the present invention is to provide a semiconductor device having at least one fuse-type memory element having an improved structure.

Another object of the present invention is to provide a semiconductor device having a fuse in which the fuse is reliably broken.

A semiconductor device according to the present invention is featured in that a hollow or trench is formed in a thick insulating layer covering a surface of a semiconductor substrate so as to laterally elongate in one direction and a fusible conductive film as a fuse is formed on the surface of the thick insulating film so as to extend in a perpendicular direction and run across the hollow or trench in the thick insulating film.

Since the fusible conductive film crosses the hollow formed in the thick insulating film, its thickness is reduced at portions on the edges of the hollow where the steps are formed on the insulating film. Accordingly, the fusible conductive film is effectively broken down at one or both of those portions in response to a programming current, and the broken point or points or the fusible conductive layer is thus predetermined.

According to another feature of the present invention, the fusible conductive film crossing the hollow is covered with a reflowable glass layer such as a borophosphosilicate glass layer. The fusible conductive film generates heat when broken down. The glass layer is thereby melted and then fills the broken portion of the fusible conductive layer. Accordingly, the scattering of the fusible conductive film is prevented, and the electrical isolation in the broken down fusible conductive film is maintained.

### BRIEF DESCRIPTION OF THE DRAWINGS

The above and other objects, features and advantages of the present invention will be more apparent from the following description taken in conjunction with the accompanying drawings, in which

Fig. 1A to Fig. 1I are cross-sectional views in manufacturing steps showing a part of a semiconductor device according to an embodiment of the present invention;

Fig. 2 is a circuit diagrams of a programmable memory device employing the fuse shown in Fig. 1 as each memory cell;

Fig. 3 is a partial, cross-sectional view showing a broken down portion of the fuse shown in Fig. 1;

Fig. 4 is a cross-sectional view showing a device according to another embodiment of the present invention;

Fig. 5 is a cross-sectional view showing a device according to a still another embodiment of the present invention; and

Fig. 6 is a circuit diagram of a programmable memory device employing the fuse shown in Fig. 5 as each memory cell.

### DETAILED DESCRIPTION OF THE EMBODIMENTS

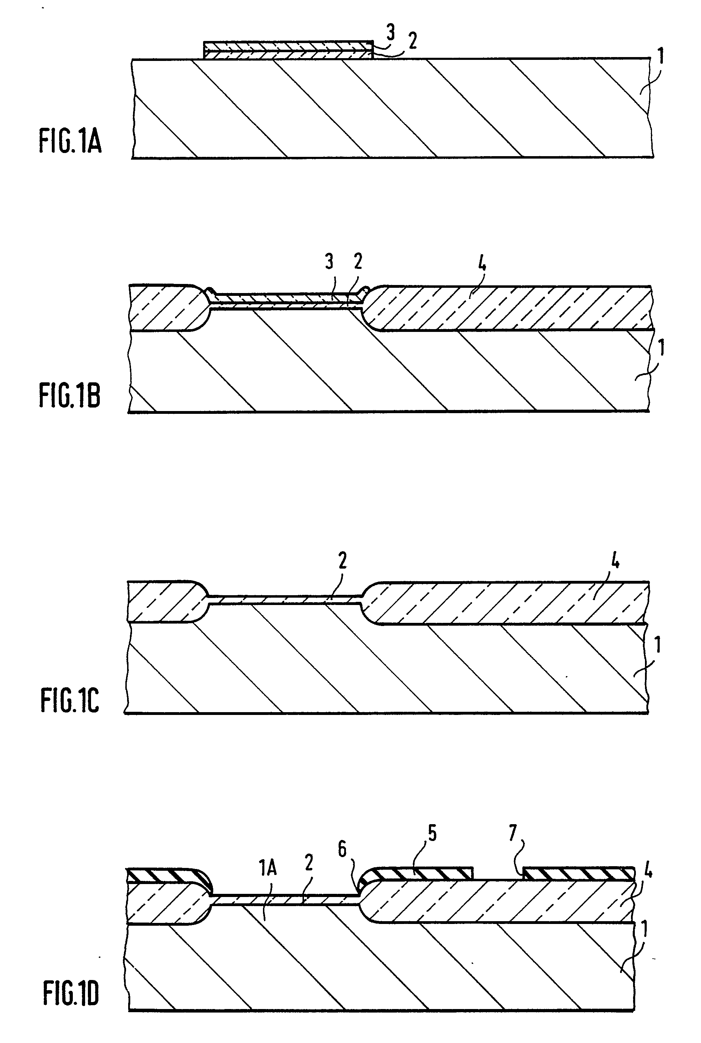

Referring to Figs. 1A to 1I, an embodiment of the present invention will be described below along with its manufacturing steps.

As shown in Fig. 1A, a P-type silicon substrate 4 having resistivity of 5 to 10 Ω-cm is prepared. A silicon oxide film 2 having a thickness of about 600 Å and a silicon nitride film 3 having a thickness of about 1000 Å are formed in that order on the substrate 1 and then selectively removed except for transistor formation portions. The nitride film 3 is employed as an oxidation-resisting film.

Referring to Fig. 1B, the substrate 1 is selectively oxidized so that a thick field insulator layer 4 of silicon oxide is selectively formed to a thickness of 5000 to 8000 Å at an exposed surface portion of the substrate 4, partially embedded in the substrate 4.

The silicon nitride film 3 is thereafter removed as shown in Fig. 1C.

Then, a photoresist layer 5 is formed to cover the entire top surface of the silicon oxide films 2 and 4 and as shown in Fig. 1D, an opening 6 is formed therein to expose the silicon oxide film 2 on the non-oxidized portion 1A of the substrate 1 where a MOS transistor is to be formed. This is a normal, well known step in a process of manufacturing a MOS transistor. According to the present invention, another opening 7 is also formed in the photoresist layer 5 at the same time, to expose a portion of the thick field insulator layer 4. Since the two openings 6 and 7 can be formed simultaneously, there occurs no increase in number of the necessary process steps.

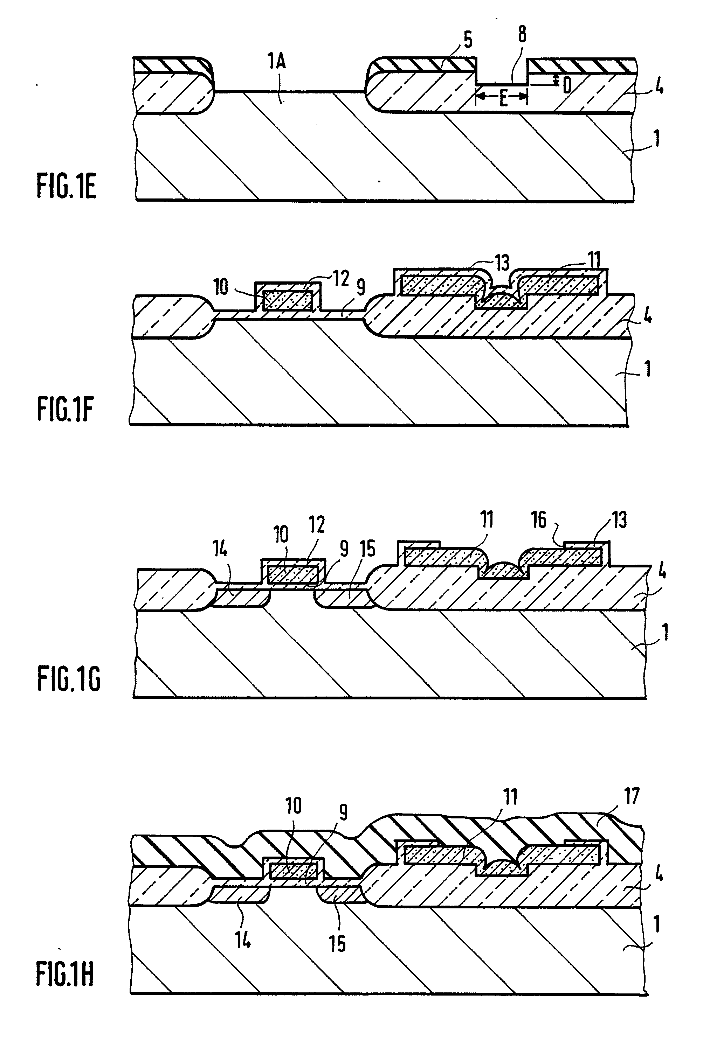

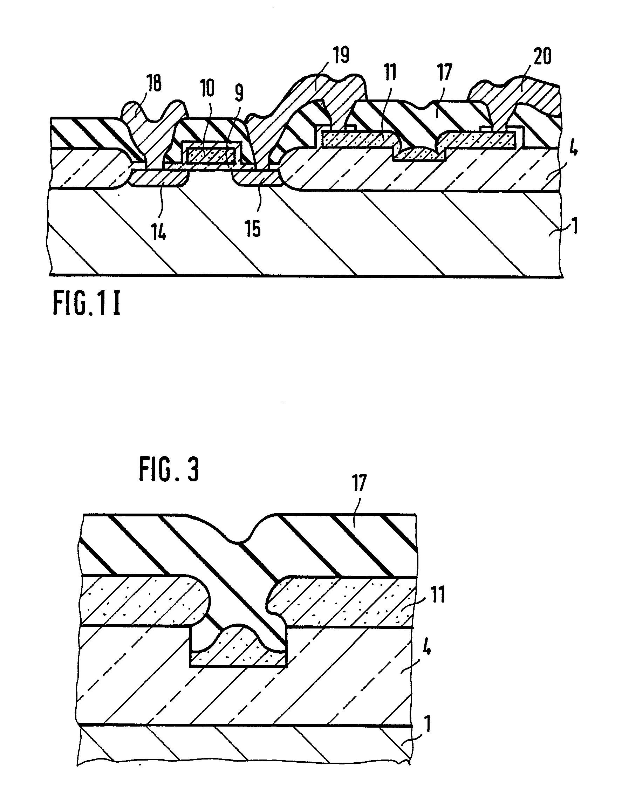

Referring to Fig. 1E, etching is performed with the photoresist layer 5 as a mask, to remove the silicon oxide film 2 entirely and at the same time to remove the exposed portion of the field oxide layer 4 to a partial depth. As a result, the transistor formation portion 1A is exposed and a hollow or trench 8 is simultaneously formed in the field oxide layer 4. In order to obtain a desired depth of the hollow 8, etching is continued even after the oxide film 2 disappears. The depth D and width E of the hollow 8 are dependent on a thickness of a fuse film to be formed thereacross. If the depth D of the hollow 8 is larger than the thickness of the fuse film, the fuse film is apt to be separated at the edge of the hollow 8 when formed on the field insulator film. As the hollow 8 becomes shallower, the smaller the reduction in the thickness of the fuse film at the edge of the hollow 8 becomes. If the width E is too small, the fuse film fills the hollow 8 completely and no thickness reduction occurs. Accordingly, relationship of the thickness of the fuse film (represented hereinunder by "T"), the depth D of the hollow 8 and the width E of the hollow 8 is favorably $\frac{1}{2}T \leq D \leq T$ and $E \geq 2T$, respectively. In this embodiment, the fuse film has a thickness T of 5000 $\mathring{A}$ and the depth D and width E are designed to be 3000 $\mathring{A}$ and 4 $\mu$m, respectively. The length of the hollow 8 is required to be larger than the width of the fuse film.

Referring to Fig. 1F, the transistor formation portion 1A is covered with a gate film 9 of silicon oxide having a thickness of 500 $\mathring{A}$ and formed by thermal oxidation. A polycrystalline silicon layer is then deposited over the entire surface and doped with phosphorus as an N-type impurity. The doped polycrystalline silicon layer is selectively removed to form, a gate electrode 10 of a MOS (Metal-Oxide-Silicon) transistor on the gate film 9 and a fuse film 11 on the thick field insulator layer 4 around the hollow 8. Thus, the doped polycrystalline layer is employed as a fusible conductive layer for the fuse 11 as well as the gate electrode 10.

The fuse 11 is elongated in a widthwise direction of the hollow 8 to run across the hollow 8. Accordingly, the thickness of the fuse 11 is reduced at its portions on the edges of the hollow 8 as shown in Fig. 1F. With the above-mentioned dimensions of the fuse 11 and the hollow 8, the thickness of the fuse film 11 is reduced to about a half at the edges of the hollow 8. The gate electrode 10 and the fuse 11 are thermally oxidized and therefore covered respectively with thin films 12 and 13 of silicon oxide.

Arsenic ions or antimory ions as an N-type impurity are selectively implanted into the transistor formation portion 1A of the substrate 1 with the gate electrode 10 and the field insulator 4 as masks, and the anealing is then carried out. N-type drain region 14 and source region 15 are thereby formed as shown in Fig. 1G. Subsequently, an opening 16 is formed in the thin film 13 to expose the upper surface and side surfaces of the portion of the fuse 11 crossing the hollow 8.

Referring to Fig. 1H, a borophosphosilicate glass (BPSG) layer 17 as a reflowable glass layer is deposited over the entire surface. The BPSG layer 17 contains boron and phosphorus in an amount of 9.0 mol % (5.0 wt %) and 5.5 mol % (9.5 wt %), respectively. Accordingly, the BPSG layer 17 is melted at a temperature above 850°C. Phosphosilicate glass (PSG) or borosilicate glass (BSG) may be employed as the glass layer 17, but BPSG is superior in stability and reflowability.

Referring to Fig. 1I, contact holes are provided in the BPSG layer 17 and the oxide film 9 and 13 to expose a portion of the drain region 14, a portion of the source region 15 and both end portions of the fuse 11. A heat treatment is then carried at temperature of about 900°C for ten minuts to moderate sharpness of the edges of the contact holes provided in the BPSG layer 17. Aluminum is thereafter deposited over the entire surface, and the patterning is then carried out. As a result, a source electrode 18, a connection 19 between the drain region 15 and one end portion of the fuse 11, and an electrode 20 connected to the other end portion of the fuse 11 are formed. A semiconductor device having the fuse 11 is thus manufactured.

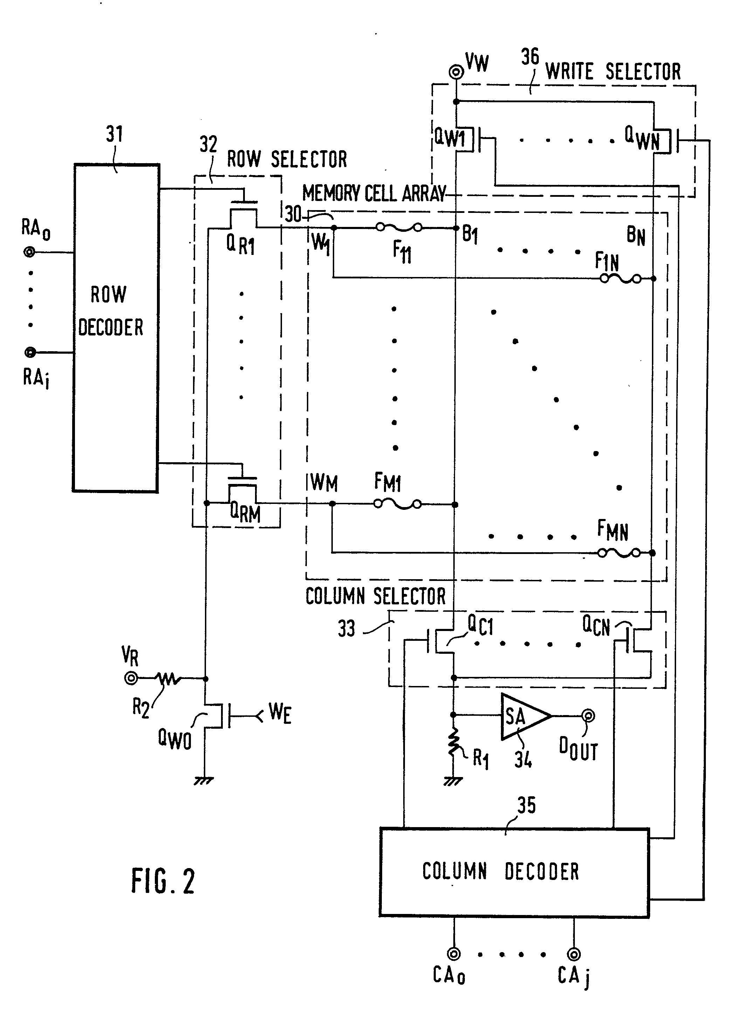

Referring to Fig. 2, a programmable memory device is shown, as an example of devices employing the fuse 11 of Fig. 1I. The fuse 11 shown in Fig. 1I is represented by "F" and used as a programmable memory element or cell in Fig. 2. A plurality of fuses $F_{11}$ to $F_{MN}$ are arranged in a matrix form to constitute a memory cell array 30. Each fuse F is connected between one of word lines $W_1$ to $W_M$ and one of bit lines $B_1$ to $B_N$. The electrodes 19 and 20 shown in Fig. 1I are alongated as the word line W and bit line B, respectively. The word lines $W_1$ to $W_M$ are connected respectively to N-channel MOS transistors $Q_{R1}$ to $Q_{RM}$ constituting a row selector 32, the gates thereof being connected to a row decoder 31. The MOS transistor shown in Fig 1I is represented by "$Q_{R1}$" in Fig. 2, for example. The electrode 18 is thus elongated and connected in common to the respective one ends of the transistors $Q_{R1}$ to $Q_{RM}$ and further to one end of a resistor $R_2$, the other end thereof being connected to a read-out voltage supply terminal $V_R$. The one end of the resistor $R_2$ is also connected to a ground through an N-channel MOS transistor $Q_{W0}$. The bit lines $B_1$ to $B_N$ are connected in common to one end of a resistor $R_1$ through N-channel MOS transistors $Q_{C1}$ to $Q_{CN}$, respectively. The transistors $Q_{C1}$ to $Q_{CN}$ constitutes a column selector 32, the gates thereof being connected to a column decoder 35. The other end of the resistor $R_1$ is grounded. The one end of the resistor $R_1$ is connected via a sense amplifier 34 to a data output terminal $D_{OUT}$. The bit lines $B_1$ to $B_M$ are further connected in common to a programming voltage supply terminal $V_W$ through N-channel MOS transistors $Q_{W1}$ to $Q_{WN}$, respectively, these transistors constituting a write selector 36.

The row decoder 31 turns ON one of the transistors $Q_{R1}$ to $Q_{RM}$ in response to a row address supplied to terminals $RA_0$ to $RA_i$. A column address is supplied to terminals $CA_0$ to $CA_j$. In data programming mode, the column decoder 35 turns ON one of the transistor $Q_{W1}$ to $Q_{WN}$ and brings all the transistors $Q_{C1}$ to $Q_{CN}$ in an OFF state. When the transistors $Q_{R1}$ and $Q_{W1}$ are turned ON in response to row and column address, the fuse $F_{11}$ is selected. In a case where data "1" is stored in the fuse $F_{11}$, the terminal $V_W$ is supplied with a programming pulse having a voltage of about 30 V and a current of about 100 mA. The transistor $Q_{W0}$ is turned ON by a signal WE in the data programming mode. The programming current thereby flows into the fuse $F_{11}$ through the transistor $Q_{W1}$ and reaches the ground via the transistors $Q_{R1}$ and $Q_{W0}$.

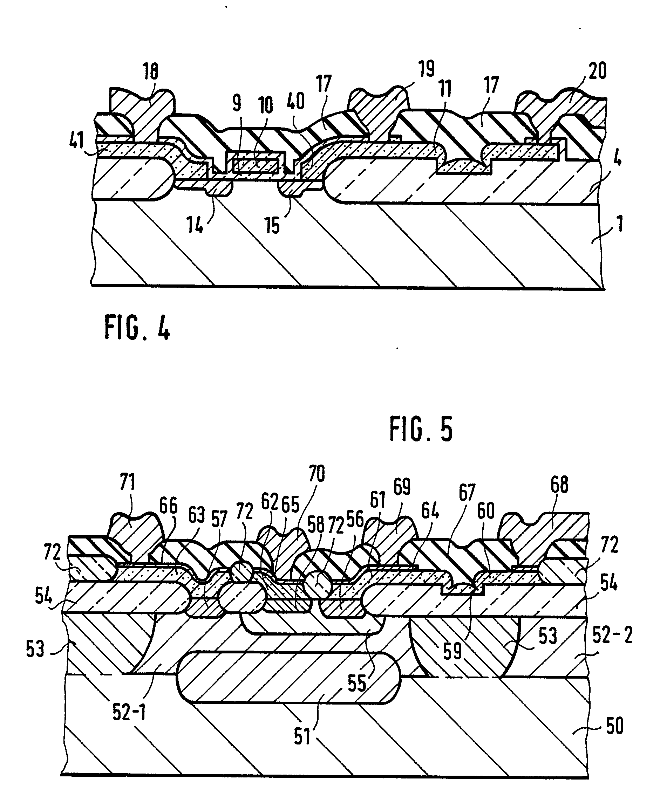

As already described, the thickness of each fuse $F_{11}$ is reduced at the edges of the hollow 8 (Fig. 1I). The current capacity is made small in the reduced thickness portions. Accordingly, the fuse 11 is blown off at the edges of the hollow 8 due to the programming current. The electric arc occurs at the blown-off points of the fuse 11. The temperature caused by the electric arc reaches about 1200°C. As a result, the BPSG glass 17 is melted and fills the blown-off portions of the fuse 11 as shown in Fig. 3.

As described above, the fuse 11 formed so as to cross the hollow 8 is effectively broken down by the programming current, and the broken points thereof are predetermined to be located at the edges of the hollow 8. Moreover, the cut-off state of the fuse 11 is secured and scattering of the blown-off fuse 11 is prevented by the BPSG glass layer 17.

It would be considered that partial reduction of the thickness of the fuse may be attained by selectively etching the fuse from its surface to a desired depth rather than relying upon the hollow 8. However, the selective etching of the fuse film requires additional manufacturing steps. In contrast, according to the present invention, the hollow 8 is formed without increasing the manufacturing steps as described with reference to Fig. 1D and it requires no additional manufacturing steps to make the fuse film 11 selectively thin.

If desired, the fuse 11 may be made of other materials such as aluminum than polycrystalline silicon.

Turning back to Fig. 2, when data "0" is stored in the selected fuse F, i.e. memory cell, the terminal $V_W$ is applied with 0V. The fuse F does not blow.

In a data read mode, the column decoder 35 turns ON one of the transistors $Q_{C1}$ to $Q_{CN}$ in response to the column address and turns OFF all the transistors $Q_{W1}$ to $Q_{WN}$. The signal WE takes the low level to turn the transistor $Q_{W0}$ OFF. When the row decoder 31 and column decoder 35 turns ON the transistors $Q_{R1}$ and $Q_{C1}$, respectively, the fuse $F_{11}$ is selected. A read-out voltage at the terminal $V_R$ is supplied to one end of the fuse $F_{11}$ via the resistor $R_2$ and the transistor $Q_{R1}$. Since the fuse $F_{11}$ is in a blown state, no current flows. Accordingly, a voltage drop does not occur across the resistor $R_1$. The sense amplifier 34 invert-amplifies a low level input and produces a high level output, i.e. an output data "1", at the output terminal $D_{OUT}$. If the selected fuse F does not blow, the voltage drop occurs across the resistor $R_1$ and an output data "0" is produced.

Fig. 4 shows another embodiment of the present invention in which the same constituents as those in Fig. 1I are denoted by the same reference numerals and their explanation is omitted. In this embodiment, one end of the polycrystalline silicon fuse 11 is extended to the transistor and connected to the drain region 15 of the transistor to function as a drain electrode 40. The source region 14 is also led out by a polycrystalline silicon electrode 41. Since the aluminum electrodes 18 and 19 are not directly contact to the regions 14 and 15, respectively, the so-called alloy spike does not occur to prevent a short-circuit of PN junctions. The regions 14 and 15 are thereby made shallow. Moreover, by utilizing the step of selectively etching the gate oxide film 9 to form the polycrystalline silicon electrodes 40 and 41, the hollow 8 can be made deeper.

Referring to Fig. 5, a still another embodiment of the present invention is shown in the form of a bipolar integrated circuit. Formed on a P-type silicon substrate 50 is an N-type epitaxial layer 52. A buried N-type layer 51 of a high impurity concentration is formed between the substrate 50 and the epitaxial layer 52. The epitaxial layer 52 comprises a plurality of island regions 52-1, 52-2, etc. isolated by a P-type isolation regions 53 of a high impurity concentration. The island region 52-1 having the buried layer 51 thereunder operates as a collector region of a bipolar transistor. A field silicon oxide layer 54 partially embedded in the epitaxial layer 52 is selectively formed. Etching of silicon oxide is performed to remove a thin silicon oxide film on the island region 52-1 and at the same time to form a hollow or trench 59 in the field oxide layer 54. A P-type base region 55 and an N-type emitter region 56 are formed in the collector region 52-1. Numerals 57 and 58 denote a collector contact region and a base contact region, respectively. A fuse 60 made of polycrystalline silicon is formed on the field oxide layer 54 to elongate across the hollow 59. One end of the fuse 60 is extended to contact with the emitter region 56 and operates as an emitter electrode 61. A base electrode 62 and a collector electrode 63 both made of polycrystalline silicon are formed on the base contact region 58 and the collector contact region 57, respectively. The electrodes 61 to 63 are separated to one another by silicon oxide films 72 and covered respectively with platinum silicide layers 64 to 66 to reduce the resistivity. A DPSG layer 67 is deposed over the entire surface and contact holes are opened therein. Aluminum electrodes 68 to 71 are formed to contact, respectively, with the other end portion of the fuse 60, the emitter electrode 61, the base electrode 62 and the collector electrode 63.

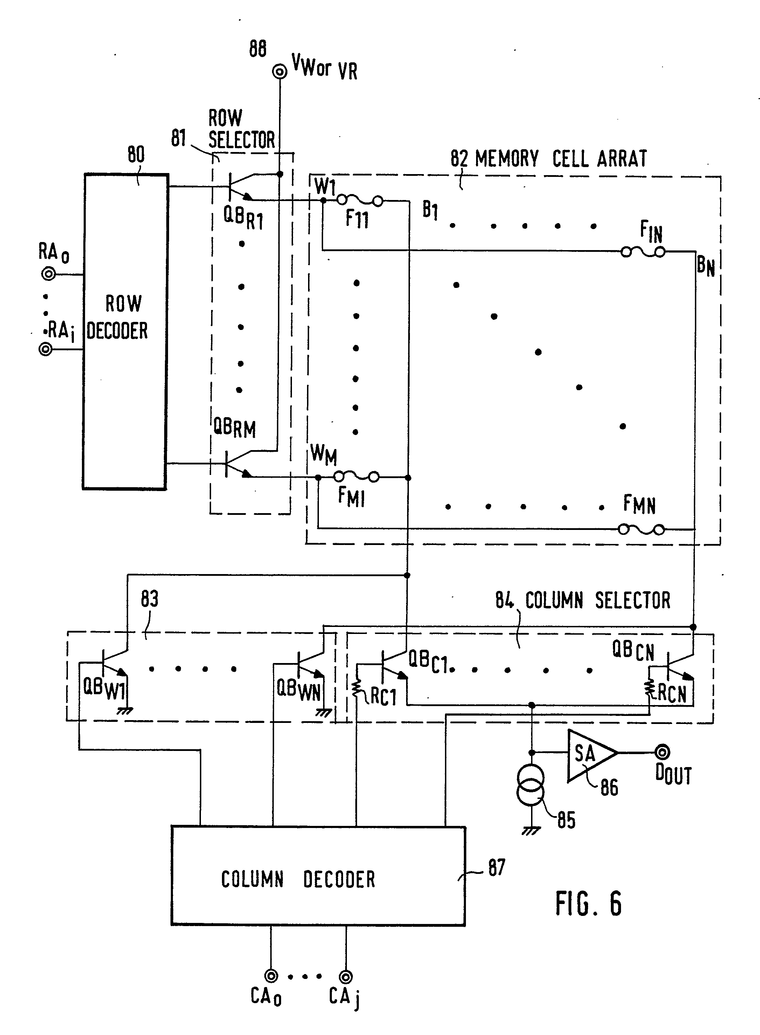

Fig. 6 shows a programmable memory device employing the fuse 60 shown in Fig. 5. In a data programming mode, a terminal 88 is supplied with a data programming power $V_W$. A row decoder 80 responds to row address data $RA_0$ to $RA_i$ and turns ON one of transistors $QB_{R1}$ to $QB_{RM}$ constituting a row selector 81. The transistor shown in Fig. 5 denotes one of the transistors $QB_{R1}$ to $QB_{RM}$. Therefore, the electrode 71 is elongated to connect the terminal 88 and the electrode 70 is elongated to connect the row decoder 80. A memory cell array 82 includes a purality of fuses $F_{11}$ to $F_{MN}$ arranged in a matrix form, one of which is denoted by the fuse 60 in Fig. 5. Therefore, the electrode 69 is elongated as one of word lines $W_1$ to $W_M$ and the electrode 68 is elongated as one of bit lines $B_1$ to $B_N$. A column decoder 87 responds to column address data $CA_0$ to $CA_j$ turns ON one of transistors $QB_{W1}$ to $QB_{WN}$ constituting a write selector 83.

On the other hand, all transistors $QB_{C1}$ to $QB_{CN}$ constituting a column selector 84 are maintained in an OFF state. When the transistors $QB_{R1}$ and $QB_{W1}$ are turned ON, the fuse $F_{11}$ is selected and supplied with the programming power. The fuse $F_{11}$ thereby blows on the edge of the hollow 59 (Fig. 5) and the BPSG layer 67 fills the blown section.

In a data read operation, the terminal 88 is supplied with a read-out voltage $V_R$. One of transistors $QB_{C1}$ to $QB_{CN}$ is turned ON in response to the column address data, and all the transistors $QB_{W1}$ to $QB_{WN}$ are maintained in the OFF state. If the selected fuse F is in the blown state, no current flows the bit line B. Therefore, a constant current source 85 draws a predetermined current only from the base-emitter junction of the turned-ON transistor $QB_C$. The voltage drop across a base resistor $R_C$ is thereby made large, so that the emitter potential of the turned-ON transistor $QB_C$ is decreased largely. A sense amplifier 86 invert-amplifies its input level and produce an output data $D_{OUT}$ of "1". If the selected fuse F does not blow, the current flowing through the resistor $R_C$ is made small, so that the decrease in emitter potential of the transistor $QB_C$ is small. Therefore, the sense amplifier 86 produces an output data $D_{OUT}$ of "0".

The present invention is not limited to the above embodiments, but may be modified and changed without departing form the scope and spirit of the invention. In particular, the number of the fuses used in a semiconductor device may be at least one.

## Claims

1. A semiconductor device comprising a semiconductor substrate, an insulating layer formed on said semiconductor substrate, and a fuse formed on said insulating layer, characterized in that a hollow is formed in said insulating layer and said fuse crosses said hollow.

2. A semiconductor device comprising a semiconductor substrate, an insulating layer covering said semiconductor substrate, a trench formed in said insulating layer, a conductive film operating as a fuse formed on said insulating layer so as to cross said trench, and a reflowable glass layer covering said conductive film.

3. The device as claimed in Claim 2, wherein said conductive film is made of polycrystalline silicon.

4. The device as claimed in Claim 2, wherein said reflowable glass is borophosphosilicate glass.

5. A semiconductor device comprising a semiconductor substrate, a transistor having a region formed in said semiconductor substrate, a thick field insulating layer formed on a field region of said semiconductor substrate, a hollow formed in said thick field insulating layer, a fuse formed on a surface of said thick field insulating film and crossing said hollow, and an interconnection line connecting said region of said transistor to said fuse.

6. The device as claimed in Claim 5, further comprising a borophosphosilicate glass layer covering said fuse.

0 241 046

FIG.1A

FIG.1B

FIG.1C

FIG.1D

FIG.1E

FIG.1F

FIG.1G

FIG.1H

FIG.1I

FIG. 3

FIG. 2

FIG. 4

FIG. 5

FIG. 6